# EUROPEAN PATENT SPECIFICATION

(11) **EP 3 012 958 B1**
(45) Date of publication and mention of the grant of the patent: **01.04.2020**
(21) Application number: 14813134.5
(22) Date of filing: 29.01.2014
(51) Int. Cl.: H05K 7/14, H05K 7/20, H02M 7/00, H02M 7/48, H02M 1/32

(54) **POWER CONVERSION DEVICE**
STROMWANDLUNGSVORRICHTUNG
DISPOSITIF DE CONVERSION DE PUISSANCE

(30) Priority: 19.06.2013 JP 2013128080
(43) Date of publication of application: 27.04.2016
(73) Proprietor: Hitachi Industrial Equipment Systems Co., Ltd., Tokyo 101-0022 (JP)
(72) Inventor: HAMANO, Koji, Tokyo 101-0022 (JP); IBORI, Satoshi, Tokyo 101-0022 (JP); HIROTA, Masayuki, Narashino-shi Chiba 275-0001 (JP); YAMAZAKI, Tadashi, Tokyo 101-0022 (JP)
(74) Representative: Strehl Schübel-Hopf & Partner
(86) International application number: PCT/JP2014/051886
(87) International publication number: WO 2014/203552

(56) References cited:
- EP-A1- 0 700 147
- WO-A1-2008/087875
- JP-A- H0 636 824
- JP-A- 2008 288 414
- JP-A- 2012 191 849
- US-A- 6 147 869
- US-A1- 2011 059 581

## Description

### TECHNICAL FIELD

The present invention relates to a power conversion device.

### BACKGROUND ART

A large number of inverters that serve as power conversion devices are employed as speed control devices of AC motors not only in the industrial world but also in home electric appliances.

In the power conversion device, a power semiconductor device (semiconductor device for power) such as an IGBT is driven by switching, thereby performing variable control of a voltage and a frequency. In the power conversion device, a semiconductor module configured by incorporating peripheral circuits such as a protective circuit in the same package, a so-called IPM (intelligent power module), is used for miniaturization.

On the other hand, requests for higher efficiency, miniaturization, and cost reduction are strong, and a package whose size is smaller than a conventional package can handle the same rating current by high performance and size reduction (shrink) of a semiconductor chip by refinement of machining technology.

However, enhancement of a degree of freedom in the manufacturing of a semiconductor module is emphasized, which does not always match user's requests due to the structure of a module.

### CITATION LIST

### PATENT LITERATURE

PATENT LITERATURE 1: JP-A-2008-288414

### NON PATENT LITERATURE

NON PATENT LITERATURE 1: Fuji Electric Review 2012, vol. 85, no. 6, P. 426 to 429

Further, EP 0 700 147 A1 and US 6147 869 A disclose power conversion devices according to the preamble of claim 1.

### SUMMARY OF INVENTION

### TECHNICAL PROBLEM

Paragraph [0051] of PATENT LITERATURE 1 describes that "a lid part 20c is placed on a substrate 50, so that a plurality of lead frames 23 come into contact with a plurality of metal foils 12 on the substrate 50. Then, contact parts are soldered, and each of the lead frames 23 is electrically connected to a corresponding one of the metal foils 12. Additionally, each lead frame 23 is bonded to a corresponding metal foil 12, so that the lid part 20c is fixed onto the substrate 50."

Lines 21 to 24 in the left column of P. 426 of NON PATENT LITERATURE 1 describe that "a module for an inverter and a converter with a brake 'small-sized flexible PIM (Power Integrated Module)' has been developed and sequenced as a new small capacity IGBT module." Additionally, line 27 of the left column to line 2 of the upper right column of P. 426 describe that "the module is different from a conventional IGBT module product in structure, and a copper base is not used, so that remarkable miniaturization and weight reduction are achieved."

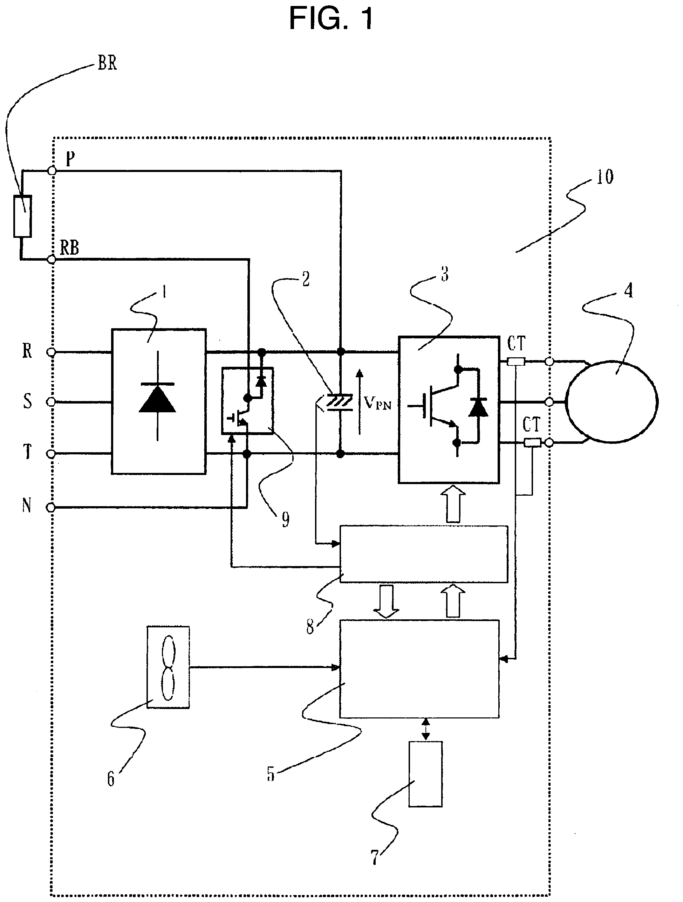

Furthermore, in the upper left on P. 427, an appearance photograph of a small-sized flexible PIM is published as a semiconductor module in Fig. 1. In the photograph, an opening through which a lead frame (lead terminal) passes, an empty opening through which the lead frame does not pass, and an opening for gel injection are disclosed. Additionally, line 18 to line 20 of the right column on P. 426 describe that "compared to a M711 package with the same rated current of a conventional product, a mounting area and a mass of the small-sized flexible PIM were reduced by 45% and 75%, respectively. Consequently, contribution to miniaturization and cost reduction of a customer device are possible."

In PATENT LITERATURE 1 and NON PATENT LITERATURE 1, the opening through which the lead frame (lead terminal) passes, and the empty opening through which the lead frame does not pass, on the upper surface of the power semiconductor module are described. A plurality of openings are provided, so that it is possible to enhance the degree of freedom in the manufacturing of the power semiconductor module. In a case where a custom power semiconductor module for exclusive use of a customer is manufactured, for example, in case where a mounting position of a semiconductor chip inside the power semiconductor, or an additional semiconductor chip is added, a plurality of openings are simply previously provided, so that the lead frame can be provided at a free place. Additionally, there is a structural advantage that a standard power semiconductor module case can be used also for the custom power semiconductor module.

However, surrounding air is supplied into the module through the empty opening through which the lead frame does not pass, and the opening for gel injection. Therefore, in a case where the power semiconductor is broken, surrounding air is easily combined, thereby easily causing ignition.

The conventional power semiconductor module is configured by hard resin or a lid, and therefore has a structure in which surrounding air is unlikely to be combined, in a case where the power semiconductor is broken.

That is, there is a problem that when the power semiconductor is broken, internal pressure inside the module increases, so that flame resulting from abnormal heat generation is blown out from the openings, and is combined with air, and fire may spread to other components or the like inside the power conversion device, to induce secondary fire spread of the power conversion device.

### SOLUTION TO PROBLEM

As a solution for attaining the above object, the power conversion device defined in Claim 1 is suggested. Further advantageous features are set out in the dependent claims..

### ADVANTAGEOUS EFFECTS OF INVENTION

According to the present invention, it is possible to prevent secondary fire spread, which caused by fire spreads to other components and the like in the power conversion device, resulting from flame caused by abnormal heat generation generated inside when the power semiconductor is broken, and blowing out from an empty opening, through which a lead frame does not pass, an opening for gel injection, and the like.

### BRIEF DESCRIPTION OF DRAWINGS

[FIG. 1] FIG. 1 is an example of a configuration diagram of a power conversion device according to the present invention.
[FIG. 2] Fig. 2 is an example of a bird's-eye view of a power conversion device according to the present invention.
[FIG. 3(a)] Fig. 3(a) is an example of a bird's-eye view (first mode) of a positioning case 16 of the power conversion device according to the present invention.
[FIG. 3(b)] Fig. 3(b) is an example of a bird's-eye view (first mode) of a positioning case 16 of the power conversion device according to the present invention.
[FIG. 3(c)] Fig. 3(c) is an example of a bird's-eye view (first mode) of a positioning case 16 of the power conversion device according to the present invention.
[FIG. 3(d)] Fig. 3(d) is an example of a front view and a bird's-eye view of a state where the positioning case 16 and the power semiconductor covered by the case 15 are mounted on the cooling fins, in the power conversion device according to the present invention.
[FIG. 3(e)] Fig. 3(e) is an example of a front view and a bird's-eye view of a state where the positioning case 16 and the power semiconductor covered by the case 15 are mounted on the cooling fins, in the power conversion device according to the present invention.
[FIG. 4(a)] Fig. 4(a) is an example of a bird's-eye view (second mode) of a case 15 of the power conversion device according to the present invention.
[FIG. 4(b)] Fig. 4(b) is an example of a bird's-eye view and a front view (second mode) of a case 15 of the power conversion device according to the present invention.
[FIG. 4(c)] Fig. 4(c) is an example of a bird's-eye view and a front view (second mode) of a case 15 of the power conversion device according to the present invention.
[FIG. 4(d)] Fig. 4(d) is an example of a bird's-eye view and a front view (second mode) of a case 15 of the power conversion device according to the present invention.
[FIG. 4(e)] Fig. 4(e) is an example of a bird's-eye view (second mode) of a case 15 of the power conversion device according to the present invention.
[FIG. 4(f)] Fig. 4(f) is an example of a bird's-eye view and a front view (second mode) of a case 15 of the power conversion device according to the present invention.
[FIG. 4(g)] Fig. 4(g) is a bird's-eye view (second mode) illustrating a state where the power semiconductor is mounted on the case 15, in the power conversion device according to the present invention.
[FIG. 5] Fig. 5 is a bird's-eye view (third mode) illustrating a relation between a substrate PCB and a case 15 of the power conversion device according to the present invention.
[FIG. 6] Fig. 6 is a diagram (fourth mode) of a state where insulating resin is coated on openings of the power semiconductor of the power conversion device according to the present invention.

### DESCRIPTION OF EMBODIMENTS

### EMBODIMENT 1

Hereinafter, the present invention will be described with reference to the drawings. Common configurations in the respective drawings are denoted by the same reference numerals. Additionally, the present invention is not limited to the examples illustrated in the drawings.

A mode in Embodiment 1 of a power conversion device according to the present invention will be hereinafter described with reference to the drawings.

Fig. 1 is an example of a configuration diagram of the power conversion device according to the present invention.

A power conversion device 10 of Fig. 1 includes a rectifier 1 for supplying power to an AC motor 4, a smoothing capacitor 2, an inverter 3, a control circuit 5, a cooling fan 6, a digital operation panel 7, a drive circuit 8, and a regenerative braking part 9. Fig. 1 illustrates a case where an AC power supply is used as an arbitrary input power supply.

The rectifier 1 converts AC power into DC power.

The smoothing capacitor 2 is provided on the output side of the rectifier 1.

The inverter 3 converts DC power into AC power with an arbitrary frequency. Inside the inverter 3, for example, an IGBT is mounted as a representative switching element. Herein, the switching element is not limited to the IGBT, and any component having a mode as the switching element may be employed.

The cooling fan 6 cools the rectifier 1, the regenerative braking part 9, and the power semiconductor module in the inverter 3.

The digital operation panel 7 sets and change various control data of the power conversion device, and performs abnormal state display and monitor display. The operation panel 7 is provided with a display part enabling abnormal display. When abnormality in the power conversion device is detected, the detected abnormality is displayed on the above display part. The type of the operation panel 7 of this embodiment is not particularly limited, but the operation panel is configured such that operation is performed while the display of the display part is viewed, in consideration of operability of a device user as the digital operation panel.

The display part does not need to be always integrated with the operation panel 7, but is desirably integrated such that an operator of the operation panel 7 can be operated while viewing the display.

The various control data of the power conversion device, which is input from the operation panel 7, is stored in a storage unit (not illustrated).

The control circuit 5 controls the inverter 3 and the switching element in the regenerative braking part 9 on the basis of the various control data input by the digital operation panel 7, and controls a whole of the power conversion device 10. The control circuit 5 is mounted with a microcomputer (control operation device), and performs a necessary control process in accordance with the various control data input from the digital operation panel 7.

Although the internal configuration is omitted, the microcomputer (control operation device) that performs operation on the basis of information from storage data of a storage unit that stores the various control data is mounted.

Current detectors CT detect respective line currents of a U phase and a W phase of the AC motor. The line current of a V phase is obtained as iv = - (iu + iw) from an AC condition (iu + iv + iw = 0).

Fig. 1 illustrates an example in which the two CT are employed. However, three CT may be used, and respective line currents of a U phase, a V phase, a W phase may be detected.

The drive circuit 8 drives the inverter 3, or the switching element in the regenerative braking part 9 on the basis of a command from the control circuit 5. A switching regulator circuit (DC/DC converter) is mounted in the drive circuit 8, and respective DC voltages necessary for operation of the power conversion device are generated to be supplied to the respective these components.

A regenerative braking resistor BR plays a role of consuming rotation energy during deceleration of the AC motor as heat energy in a resistor.

In a case where not an AC power supply but a DC power supply is supplied as an arbitrary input power supply, the + side of the DC power supply may be connected to a DC terminal P side, and the - side of the DC power supply may be connected to a DC terminal N side.

Furthermore, AC terminals R, S and T may be connected, and this connection point may be connected to the + side of the DC power supply, and the - side of the DC power supply may be connected to the DC terminal N side. On the contrary, the + side of the DC power supply may be connected to the DC terminal P side, AC terminals R, S and T may be connected, and this connection point may be connected to the - side of the DC power supply.

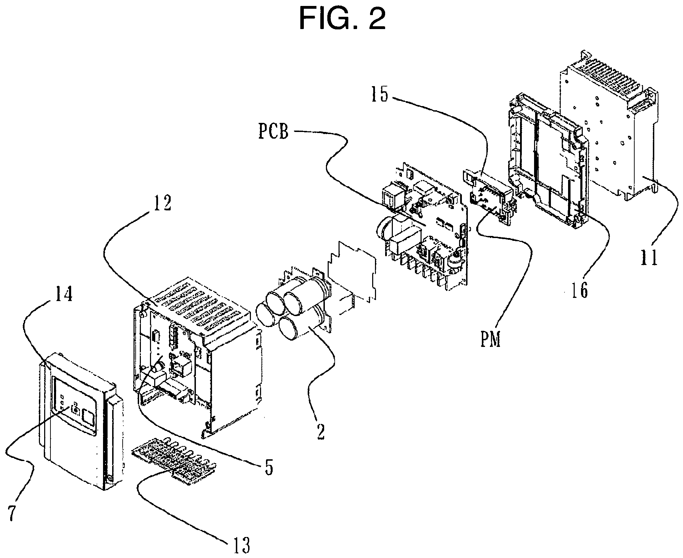

Fig. 2 is an example of a bird's-eye view of a power conversion device according to the present invention.

A mode in Embodiment 2 of the power conversion device according to the present invention will be described with reference to the drawing.

Common configurations and the same functions as those of Fig. 1 are denoted by the same reference numerals.

A power semiconductor PM is a module configured by a rectifier 1, an inverter 3, and a regenerative braking part 9. A state where a case 15 is mounted on the power semiconductor is illustrated.

The power semiconductor PM is fixed to cooling fins by screws (not illustrated). A lead terminal of the power semiconductor passes through a through hole provided in a substrate PCB mounted with a drive circuit 8, and is electrically connected to solder.

A substrate mounted with a control circuit 5 and the substrate PCB mounted with the drive circuit 8 are connected by an electric wire.

In this embodiment, the shape of a distal end of the lead terminal of the power semiconductor is a solder pin. However, the intention of the present invention is not changed even in a case where the shape is a press fit pin which does not use solder.

Cooling fins 11 conduct heat from the power semiconductor that is a heating element, air is sent to the cooling fins by a cooling fan (not illustrated) to be subjected to heat exchange and to be radiated by an air cooling system.

A positioning case 16 is previously provided with an opening corresponding to the power semiconductor such that a mounting position of the power semiconductor can be easily determined when the power semiconductor PM is mounted on the cooling fins, and fixes a mounting position of the power semiconductor.

In this embodiment, the module is configured by the rectifier 1, the inverter 3, and the regenerative braking part 9 as an example. However, even when a power semiconductor configured only by the rectifier 1, and two power semiconductors configured by the inverter 3 and the regenerative braking part 9 are used, or even when three power semiconductors independently configured by the rectifier 1, the inverter 3 and the regenerative braking part 9 are used, the intention of the invention is not changed.

A housing of the power conversion device includes the cooling fins 11, a casing 12, an electric wire drawing plate 13, and a front surface cover 14.

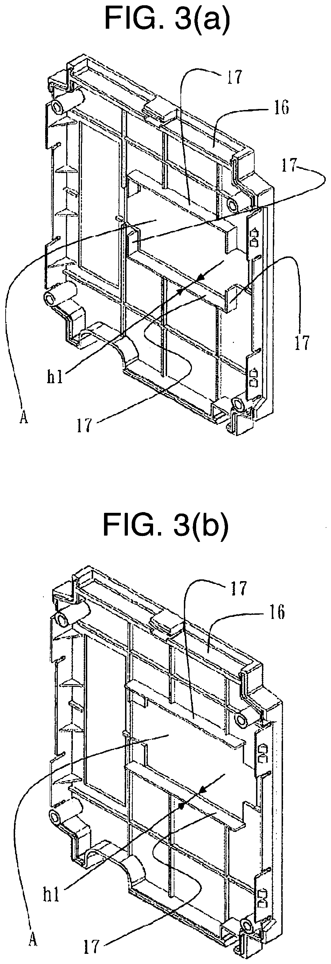

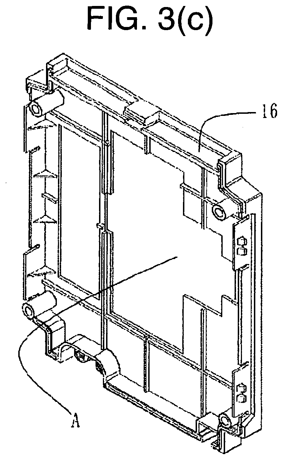

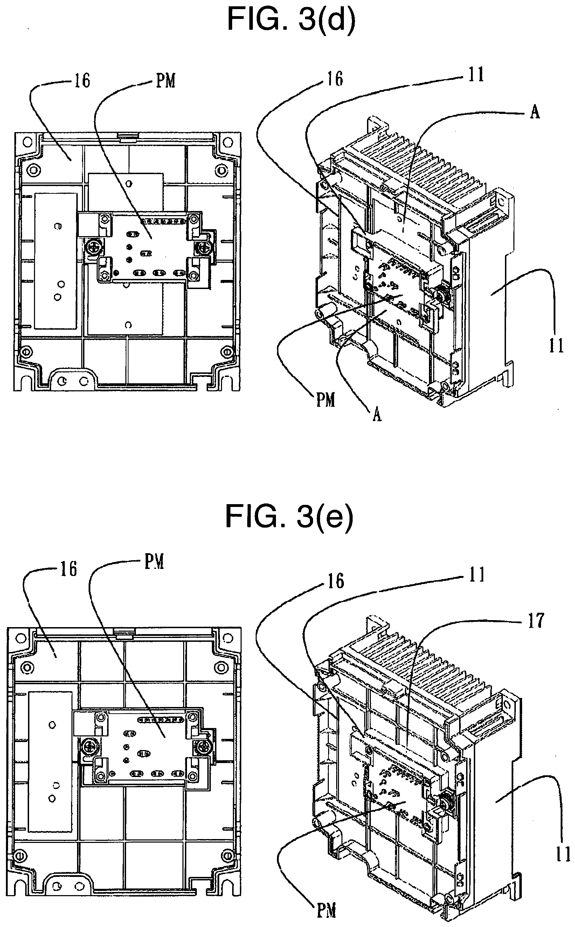

Fig. 3 is a bird's-eye view (first mode) of the positioning case 16 of the power conversion device according to the present invention.

A mode in Embodiment 3 of the power conversion device according to the present invention will be hereinafter described with reference to the drawings.

Fig. 3(a) is a bird's-eye view in which projections (barriers) 17 are provided on four sides of an opening A provided in the positioning case 16 corresponding to the power semiconductor PM.

Fig. 3(b) is a bird's-eye view in which projections (barriers) 17 are provided on two sides of an opening A provided in the positioning case 16.

Fig. 3(c) is a bird's-eye view in which no projection (barrier) is provided in an opening A provided in the positioning case 16.

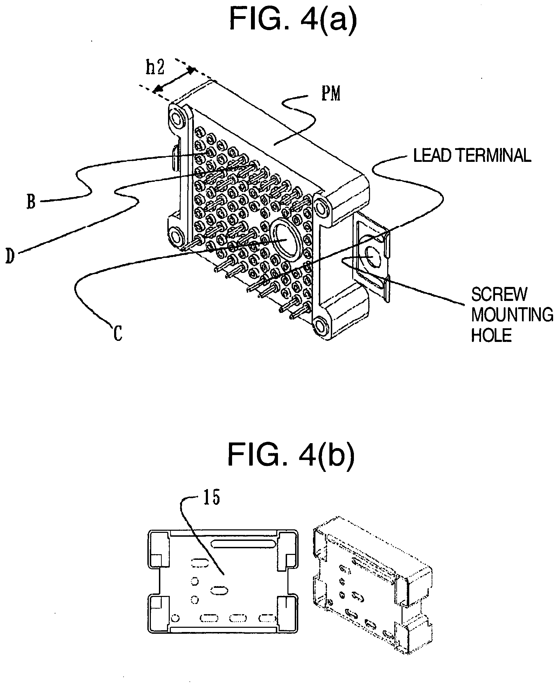

The height h1 of each projection 17 is designed to be lower than the height h2 (see Fig. 4(a)) of the power semiconductor PM. Of course, a case where the projections 17 are provided on the four sides of the opening A, a case where the projections 17 are provided on the two sides of the opening A, and a case where the projections 17 are not provided are illustrated. However, the number of projections to be provided is not limited.

Fig. 3(d) is a front view and a bird's-eye view of a state where the positioning case 16 described in Fig. 3(c) and the power semiconductor covered by the case 15 are mounted on the cooling fins.

Fig. 3(e) is a front view and a bird's-eye view of a state where the positioning case described in Fig. 3(a) and the power semiconductor covered by the case 15 are mounted on the cooling fins.

It is found that the projections 17 on the four sides provided in the positioning case 16 press the case 15 which covers the power semiconductor PM, and clearances with the power semiconductor can be reduced such that flame caused by abnormal heat generation is not blown out by rise of internal pressure inside the module when the power semiconductor is broken.

In Fig. 3(a) in which the projections are provide on the four sides of the opening A provided in the positioning case, clearances on the four sides can be reduced compared to Fig. 3(c) in which the projections are not provided in the opening A, and an effect of suppressing force of blowing out flame is large.

### EMBODIMENT 2

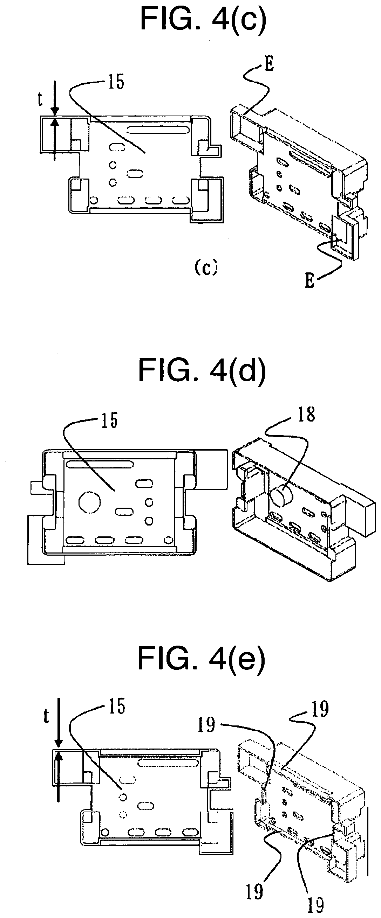

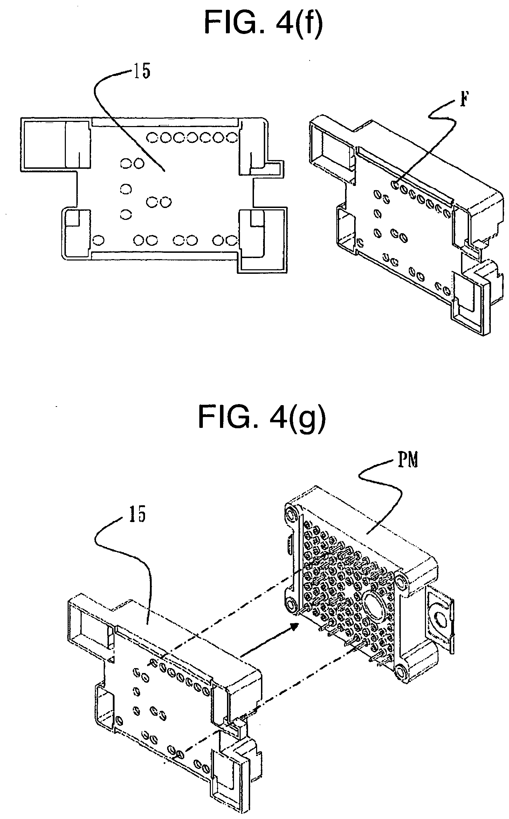

Fig. 4 is a bird's-eye view (second mode) of a case 15 according to the power conversion device of the present invention.

A mode in Embodiment 2 of the power conversion device according to the present invention will be hereinafter described with reference to the drawings.

Fig. 4(a) is an example of a bird's-eye view of a power semiconductor PM which has 69 empty openings B through which lead terminals do not pass, and an opening C for gel injection. Of course, clearances exist also in contact surfaces D through which 20 lead terminals pass.

The reason why a plurality of openings are provided is that in a case where a custom power semiconductor module exclusive for a customer is manufactured, the plurality of openings are previously provided, so that a lead frame can be provided at a free place, and a standard power semiconductor module case can be used for the custom power semiconductor module, which is an advantage in manufacture.

Fig. 4(b) is a front view and a bird's-eye view of a case 15 according to an embodiment. Oval openings and circular openings are provided in a cover so as to correspond to all lead terminal positions of the power semiconductor. Of course, the openings may be quadrilateral openings.

Even when the power semiconductor PM is covered by the case 15, the lead terminals is connected to a substrate PCB project from the cover. The covering by the case 15 can suppress flame blown out from the openings.

Fig. 4(c) is a front view and a bird's-eye view of a case 15 according to another embodiment. The cover in Fig. 4(c) is different from the cover described in the embodiment of Fig. 4(b) in that the cover has protruding parts E provided on both ends in order to ensure electric insulation distances among components mounted on the back surface of the substrate PCB, lead legs of components, and screws for mounting the power semiconductor on cooling fins. This example will be described later in detail.

Fig. 4(d) is a front view and a back surface bird's-eye view of a case 15 in which a projection part (boss) 18 that closes an opening C for gel injection of a power semiconductor is provided. The bird's-eye view illustrates a state where the case 15 is viewed from the back surface such that the projection part 18 can be distinguished. The projection part is provided with slight taper so as to facilitate insertion to the opening for gel injection, and is tapered. Of course, the projection part (boss) may be quadrilateral projection part (boss).

The length of the projection part may be designed in accordance with the depth of the opening for gel injection of the power semiconductor.

Fig. 4(e) is a front view and a bird's-eye view of a case provided with projection parts 19 on four sides. The projection parts 19 provided on the four side of the case is configured such that the back surface of a substrate PCB plays a role of a lid by contact between the projection parts provided on the four sides and the back surface of the substrate PCB mounted with a drive circuit 8, and clearances can be eliminated. Of course, places where the projection parts 19 are provided are not limited to the four sides. Even when the projection parts 19 are provided on two sides, an effect is obtained. According to the method of Fig. 4(e), the clearances can be effectively eliminated, compared to the cases of the embodiments in Fig. 4(b) to Fig. 4(d). This example will be described later in detail.

Fig. 4(f) is a front view and a bird's-eye view of a case provided with 20 circular openings F so as to correspond the shapes and the number of lead terminals of a power semiconductor. The openings correspond to the shapes of the lead terminals, so that clearances between the lead terminals and the openings of the case can be further reduced compared to the cases of the embodiments in Fig. 4(b) to Fig. 4(e).

Fig. 4(g) is a bird's-eye view illustrating a state where the power semiconductor is mounted on the case. The case moves in the direction of the arrow to cover the power semiconductor, so that the 20 lead terminals of the power semiconductor pass through the openings provided in the case 15, thereby covering the power semiconductor with the cover, which is an object and a feature of the present invention. Additionally, the thickness t of the case is designed to be 0.71 mm or more.

The case covers the power semiconductor, and prevents secondary fire spread caused by fire spreads to other components in the power conversion device, resulting from flame caused by abnormal heat generation generated inside when the semiconductor module is broken, and blowing out from the empty openings B, through which the lead frames do not pass, and the opening C for gel injection. The case is molded by use of insulating resin such as silicon and plastic. In consideration of ease of handling, it can be said that a case molded by silicon having high flexibility is realistic in operability.

### EMBODIMENT 3

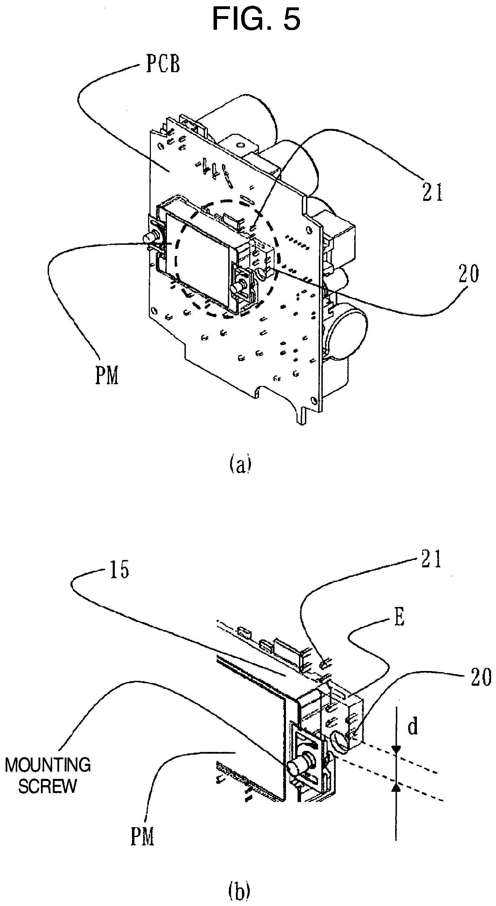

Fig. 5 is a bird's-eye view (third mode) illustrating a relation between a substrate PCB and a case 15 of a power conversion device according to the present invention.

A mode in Embodiment 3 of the power conversion device according to the present invention will be hereinafter described with reference to the drawings.

Common configurations and the same functions as those of Fig. 2 are denoted by the same reference numerals.

Fig. 5(a) is a bird's-eye view illustrating a state where lead terminals of the power semiconductor pass through the through holes (not illustrated) of a substrate PCB mounted with a drive circuit 8, and are electrically connected by solder.

The bird's-eye view is a diagram viewed from the back surface of the substrate.

Lead legs of mounted components pass through the through hole (not illustrated) of the substrate, and protrude from the back surface of the substrate. Representative lead legs that protrude from the back surface are denoted by 20 and 21.

A power semiconductor covered with a case 15, and a positioning case 16 are mounted on cooling fins, and lead terminals of the power semiconductor are inserted into the through holes of the substrate to be connected by solder. Therefore, the projection parts 19 provided on the four sides of the case 15 illustrated in Fig. 4(e) come into contact with the back surface of the substrate, so that the back surface of the substrate PCB plays a role of a lid, and clearances can be eliminated. Of course, mounting of the components of the substrate should be previously designed so as to avoid the projection parts such that the components are not mounted at parts where the back surface of the substrate and the projection parts come into contact.

Fig. 5(b) is an enlarged view of a part surrounded by dotted lines in Fig. 5(a).

The power semiconductor is mounted on a cooling fin (not illustrated) by a mounting screw. This embodiment is an embodiment of a case where a distance d between a head of this screw and the lead leg 20 of the mounted component which protrudes from the back surface of the substrate is less than a predetermined insulation distance. The lead leg is surrounded by a protruding part E for securing an electric insulation distance, which is provided in the cover 15 that covers the power semiconductor, and therefore the insulation distance can be reduced, and miniaturization of the power conversion device can be attained.

Thus, it is possible to prevent secondary fire spread caused by fire spreads to other components and the like in the power conversion device due to flame blowing out from the openings.

### EMBODIMENT 4

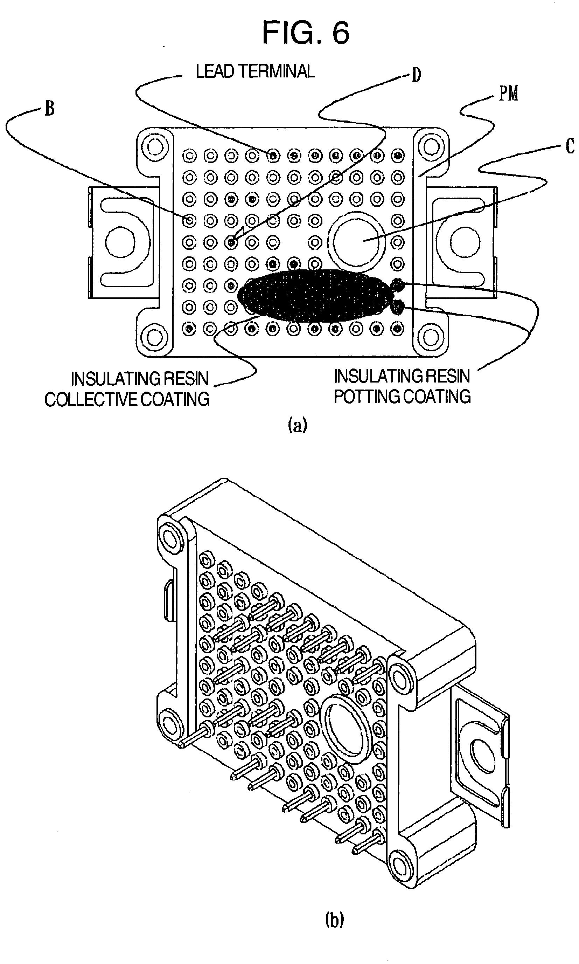

Fig. 6 is a diagram (fourth mode) of a state where insulating resin is coated on openings of a power semiconductor of a power conversion device according to the present invention.

A mode in Embodiment 4 of the power conversion device according to the present invention will be hereinafter described with reference to the drawings.

Embodiment 4 is different from Embodiment 1 in that silicon or insulating resin is coated on openings B or an opening C for gel injection to close the opening(s) in place of the molded case 15.

In Fig. 6(a), a place at which insulating resin is collectively coated on some of openings of the power semiconductor, and places at which potting coating is performed are illustrated as an example, as a representative coating method. Insulating resin may be coated on all the openings (B and C) by one of these methods (collective coating or potting coating). Alternatively, coating of insulating resin on all the openings (B and C) by use of both methods (collective coating and potting coating) is more realistic in consideration of a working property. Of course, silicon or insulating resin may be coated around openings D through which lead frames pass.

Fig. 6(b) is an enlarged bird's-eye view of the power semiconductor, illustrating a relation between the openings and the lead terminals.

As described in the above embodiments, according to the present invention, it is possible to prevent secondary fire spread in the power conversion device, which caused by fire spreads to other components and the like in the power conversion device, resulting from flame caused by abnormal heat generation generated inside when the semiconductor module is broken, and blowing out from the empty openings, through which the lead frames do not pass, the opening for gel injection, and the like.

### REFERENCE SIGNS LIST

1 ... Rectifier, 2 ... Smoothing capacitor, 3 ... Inverter, 4 ... AC motor, 5 ... Control circuit, 6 ... Cooling fan, 7 ... Digital operation panel, 8 ... Drive circuit, 9 ... Regenerative braking part, 10 ... Power conversion device, 11 ... Cooling fin, 12 ... Casing, 13 ... Electric wire drawing plate, 14 ... Front surface cover, 15 ... Case, 16 ... Positioning case, 17 ... Projection, 18 ... Projection part (boss) provided in case, 19 ... Projection part provided in case, 20, 21 ... Lead leg of component, PM ... Power semiconductor, BR ... Regenerative braking resistor, CT ... Current detector

## Claims

1. A power conversion device comprising:
a power semiconductor (PM);
a cooling fin (11) configured to cool the power semiconductor;
a first case (16) disposed on the cooling fin, and including an opening (A) corresponding to a shape of the power semiconductor through which the power semiconductor is mounted on the cooling fin; and
a second case (15) configured to cover the power semiconductor mounted on the cooling fin, and comprising openings through which lead terminals of the power semiconductor pass;
**characterized in that**
the second case includes a projection (18) that covers an opening (C) for gel injection provided in the power semiconductor between the lead terminals.

2. The power conversion device according to claim 1, wherein
the second case (15) is formed by silicon.

3. The power conversion device according to claim 1, wherein
the second case (15) is formed by plastic resin or insulating resin.

4. The power conversion device according to claim 1, wherein
the second case (15) has a thickness of 0.71 mm or more.

5. The power conversion device according to claim 1, wherein
the opening (A) of the first case (16) corresponds to a size of the power semiconductor (PM).

6. The power conversion device according to claim 5, wherein
the opening (A) of the first case (16) has a projection (17) provided on at least one side thereof.

7. The power conversion device according to claim 6, wherein
a height of the projection (17) of the first case (16) is lower than a height of the power semiconductor (PM).

8. The power conversion device according to claim 1, wherein
the lead terminal openings of the power semiconductor (PM) are closed by silicon or insulating resin.

9. The power conversion device according to claim 1, wherein
the opening (C) for gel injection of the power semiconductor (PM) is closed by silicon or insulating resin.

10. The power conversion device according to claim 1, wherein
the power semiconductor (PM) is formed by a plurality of power semiconductor chips.

## Patentansprüche

1. Stromwandlungsvorrichtung, umfassend:
einen Leistungshalbleiter (PM);
eine Kühllamelle (11), die dazu eingerichtet ist, den Leistungshalbleiter zu kühlen;
ein erstes Gehäuse (16), das auf der Kühllamelle angeordnet ist und eine Öffnung (A) enthält, die einer Form des Leistungshalbleiters entspricht und durch die der Leistungshalbleiter auf der Kühllamelle angebracht ist; und
ein zweites Gehäuse (15), das dazu eingerichtet ist, den auf der Kühllamelle angebrachten Leistungshalbleiter abzudecken, und das Öffnungen, durch die Führungsanschlüsse des Leistungshalbleiters verlaufen, umfasst:
**gekennzeichnet dadurch, dass**
das zweite Gehäuse einen Vorsprung (18) enthält, der eine Öffnung (C) zur Gelinjektion abdeckt, die zwischen den Führungsanschlüssen im Leistungshalbleiter vorgesehen ist.

2. Stromwandlungsvorrichtung nach Anspruch 1, wobei
das zweite Gehäuse (15) durch Silizium gebildet ist.

3. Stromwandlungsvorrichtung nach Anspruch 1, wobei
das zweite Gehäuse (15) durch Kunstharz oder Isolierharz gebildet ist.

4. Stromwandlungsvorrichtung nach Anspruch 1, wobei
das zweite Gehäuse (15) eine Dicke von 0,71 mm oder mehr aufweist.

5. Stromwandlungsvorrichtung nach Anspruch 1, wobei
die Öffnung (A) des ersten Gehäuses (16) einer Größe des Leistungshalbleiters (PM) entspricht.

6. Stromwandlungsvorrichtung nach Anspruch 5, wobei
die Öffnung (A) des ersten Gehäuses (16) einen Vorsprung (17) aufweist, der auf mindestens einer Seite vorgesehen ist.

7. Stromwandlungsvorrichtung nach Anspruch 6, wobei
eine Höhe des Vorsprungs (17) des ersten Gehäuses (16) geringer als eine Höhe des Leistungshalbleiters (PM) ist.

8. Stromwandlungsvorrichtung nach Anspruch 1, wobei
die Führungsanschlussöffnungen des Leistungshalbleiters (PM) durch Silizium oder Isolierharz verschlossen sind.

9. Stromwandlungsvorrichtung nach Anspruch 1, wobei
die Öffnung (C) zur Gelinjektion des Leistungshalbleiters (PM) durch Silizium oder Isolierharz verschlossen ist.

10. Stromwandlungsvorrichtung nach Anspruch 1, wobei
der Leistungshalbleiter (PM) durch mehrere Leistungshalbleiterchips gebildet ist.

## Revendications

1. Dispositif de conversion de puissance comprenant :
un semi-conducteur de puissance (PM) ;
un ailette de refroidissement (11) configurée pour refroidir le semi-conducteur de puissance ;
un premier boîtier (16) disposé sur l'ailette de refroidissement, et incluant une ouverture (A) correspondant à une forme du semi-conducteur de puissance à travers laquelle le semi-conducteur de puissance est monté sur l'ailette de refroidissement ; et
un deuxième boîtier (15) configuré pour recouvrir le semi-conducteur de puissance monté sur l'ailette de refroidissement, et comprenant des ouvertures à travers lesquelles des bornes de conducteurs du semi-conducteur de puissance passent ;
**caractérisé en ce que**
le deuxième boîtier inclut une projection (18) qui recouvre une ouverture (C) pour injection de gel prévue dans le semi-conducteur de puissance entre les bornes de conducteurs.

2. Dispositif de conversion de puissance selon la revendication 1, dans lequel
le deuxième boîtier (15) est constitué de silicone.

3. Dispositif de conversion de puissance selon la revendication 1, dans lequel
le deuxième boîtier (15) est constitué d'une résine plastique ou d'une résine d'isolation.

4. Dispositif de conversion de puissance selon la revendication 1, dans lequel
le deuxième boîtier (15) a une épaisseur de 0,71 mm ou plus.

5. Dispositif de conversion de puissance selon la revendication 1, dans lequel
l'ouverture (A) du premier boîtier (16) correspond à une taille du semi-conducteur de puissance (PM).

6. Dispositif de conversion de puissance selon la revendication 5, dans lequel
l'ouverture (A) du premier boîtier (16) a une projection (17) prévue sur au moins un côté de celle-ci.

7. Dispositif de conversion de puissance selon la revendication 6, dans lequel
une hauteur de la projection (17) du premier boîtier (16) est inférieure à une hauteur du semi-conducteur de puissance (PM).

8. Dispositif de conversion de puissance selon la revendication 1, dans lequel
les ouvertures pour bornes de conducteurs du semi-conducteur de puissance (PM) sont fermées par du silicone ou une résine d'isolation.

9. Dispositif de conversion de puissance selon la revendication 1, dans lequel
l'ouverture (C) pour injection de gel du semi-conducteur de puissance (PM) est fermée par du silicone ou une résine d'isolation.

10. Dispositif de conversion de puissance selon la revendication 1, dans lequel
le semi-conducteur de puissance (PM) est formé par une pluralité de puces à semi-conducteur de puissance.
